# EUROPEAN PATENT APPLICATION

(11) **EP 4 582 830 A1**
(43) Date of publication of application: **09.07.2025**
(21) Application number: 24150753.2
(22) Date of filing: 08.01.2024
(51) Int. Cl.: G01S 7/02, E05B 15/02, G01S 13/931, H05K 5/00, B65D 45/22, G01S 7/481

(54) **WIRE SPRING SENSOR CLOSURE**

(71) Applicant: GM Cruise Holdings LLC, San Francisco, CA 94107 (US)
(72) Inventor: KOEPP, Johannes, 85521 Ottobrunn (DE); PATEL, Rahul, 85521 Ottobrunn (DE); WILLMS, Manuel, 85521 Ottobrunn (DE)
(74) Representative: Berkenbrink, Kai-Oliver

(57) **Abstract**

A sensor housing system comprises an upper housing portion (302), a lower housing portion (304), and a wire spring closure device having a closure feature configured to secure the upper housing portion to the lower housing portion. The wire spring closure device comprises an upper portion (210) comprising an upper retaining bar (212), and a spring portion (214) coupled to the upper portion. The wire spring closure device also comprises a lower portion (206) coupled to the spring portion and comprising a lower retaining bar (208).

## Description

### BACKGROUND

Autonomous or assisted driving strategies have been facilitated through sensing an environment around a vehicle. Radar sensors are conventionally used in connection with detecting and classifying objects in an environment. Radar is particularly robust with regard to lighting and weather conditions. Often, radar sensors are deployed with cameras and/or lidar sensors to provide different modes of detection and redundancy. In certain scenarios, performance of lidar and/or cameras can be supplemented by radar when affected by environmental features, such as temperature, fog, rain, snow, bright sunlight, lack of adequate light, etc.

Autonomous vehicles often have to operate in extreme temperatures and other extreme conditions. Sensor systems (e.g., radar sensors, camera sensors, lidar sensors, sonar sensors, etc.) on autonomous vehicles need to be secured within durable housings that protect the sensors from the elements. Additionally, sensor housings need to be able to tolerate large temperature ranges, including extremely low temperatures that can cause the sensor housing to contract and extremely high temperatures that can cause the sensor housing to expand. Contraction and expansion of the sensor housing can deteriorate the effectiveness of fasteners used to hold the sensor housing together. This problem can be exacerbated when the fasteners used to hold the sensor housing together are of a different material than the housing itself, and therefore have different expansion and contraction properties.

While conventional approaches allow for coupling housing portions together, these approaches have not satisfactorily addressed problems created by extreme temperature ranges and their effect on different housing and fastener material tolerances.

### SUMMARY

The following is a brief summary of subject matter that is described in greater detail herein. This summary is not intended to be limiting as to the scope of the claims.

Described herein are various technologies relating to removably and lockably securing portions of a housing together, and more specifically, to providing a wire spring closure device for securely mating housing portions together. In one embodiment, the housing is a sensor housing for housing a sensor (e.g., radar, lidar, camera, sonar, etc.) employed in autonomous vehicles, aircrafts, watercrafts, and the like.

Sensor housings for various sorts of sensors are often exposed to extreme ranges of conditions such as temperature. For instance, a radar sensor on a vehicle may experience a temperature range of 100°C or more in a 24 hour period or less. Additionally, sensor housings manufactured in an indoor climate-controlled facility have to be able to accommodate extreme cold and extreme heat depending on the geographical region of their deployment. Sensor housings deployed on aircraft may experience temperatures of 50°C or more on the ground and -50°C or less at altitude. Given these extreme temperature ranges, housing closure devices need to have large temperature tolerances.

Conventional fasteners such as glue can become brittle at low temperatures and melt at high temperatures. Mechanical fasteners such as screws and clips contract as temperature drops and expand as temperature increases. Moreover, often the housing and the fasteners are of different materials that do not expand or contract at the same rate. Moreover, the housing portions that are being mated together may be of different materials. For instance, a first housing portion may be formed of a first plastic and another may be formed of a metal or another plastic that is denser than the first plastic. A screw used to fasten the two housing portions together may provide a secure coupling when the housing portions are originally secured, but the coupling can become compromised over time due to the different thermal tolerances of the different materials used for the two housing portions. For instance, the plastic portion may expand and contract much more during temperature changes than the metal portion. A mechanical fastener such as a metal screw may not contract as much as the plastic material, causing a loose fit at low temperatures.

Aspects described herein relate to a wire spring closure device configured to securely couple upper and lower housing portions together for, e.g., housing a radar sensor or the like (e.g., a lidar sensor, a sonar sensor, a camera sensor, or any other suitable sensor). In other applications, the described wire spring closure device can be used for larger applications such as cargo containers, storage containers, etc. The described wire spring closure device securely and removably couples the upper and lower housing portions and maintains the secure coupling despite the effects of extreme temperature ranges on the contraction and expansion of the upper and lower housing portion materials.

The wire spring closure device comprises an upper portion coupled to a spring portion which in turn is coupled to a lower portion. The upper portion comprises an upper retaining bar, and the lower portion comprises a lower retaining bar. The lower portion mates with receiving slots in a retaining structure on a lower housing portion such that the lower retaining bar is positioned against a lower surface of the retaining structure on the lower housing portion. The upper portion of the wire spring closure device is engaged with the upper housing portion by forcing the upper retaining bar along a sloped mating feature on the upper housing portion until the upper retaining bar drops into retaining notches in the upper housing portion. As the upper retaining bar traverses the sloped mating feature, the spring portion of the wire spring closure device is stretched. Once the upper retaining bar drops into the retaining notches on the upper housing portion, the spring portion of the wire spring closure device is locked in a stretched or extended state and biases the upper housing portion against the lower housing portion to securely and removably lock the upper and lower portions together.

In one embodiment, the upper housing portion comprises a heat sink with cooling fins. One or more of the cooling fins is modified to have a sloped edge along which the upper retaining bar is forced during engagement, and a retaining notch into which the upper retaining bar drops after traversing the sloped edge.

In another embodiment, the described housing portions and wire spring closure device form a sensor housing system that can be deployed on an autonomous vehicle.

The above summary presents a simplified summary in order to provide a basic understanding of some aspects of the systems and/or methods discussed herein. This summary is not an extensive overview of the systems and/or methods discussed herein. It is not intended to identify key/critical elements or to delineate the scope of such systems and/or methods. Its sole purpose is to present some concepts in a simplified form as a prelude to the more detailed description that is presented later.

### BRIEF DESCRIPTION OF THE DRAWINGS

Fig. 1A illustrates a sensor housing that comprises an upper portion and a lower portion and houses a plurality of component layers.
Fig. 1B shows the sensor housing wherein the housing portions are not held flush against one another by the clip due to expansion of the component layers therein.
Fig. 2 is a perspective view of the herein-described wire spring closure device.
Fig. 3 illustrates a perspective view showing an upper housing portion, lower housing portion, and the herein-described wire spring closure device.
Fig. 4 illustrates another perspective view showing the upper housing portion, lower housing portion, and wire spring closure device.
Fig. 5 shows a side view of the upper housing portion and the lower housing portion prior to engagement of the wire spring closure device by the closure tools.
Fig. 6 shows a side view the upper housing portion and the lower housing portion after engagement of the wire spring closure device by the closure tools.
Fig. 7 illustrates another perspective view of the upper housing portion, lower housing portion, and wire spring closure device in a locked configuration.
Fig. 8 is a perspective view of the wire spring closure device in a locked configuration securing together the upper housing portion and the lower housing portion.
Fig. 9 is a top-down view of the upper housing portion.
Fig. 10 is a rear view of the wire spring closure device in an unlocked, unstretched state.
Fig. 11 is a rear view of the wire spring closure device in an extended or stretched state such as after it has been moved into a locked position.
Fig. 12 illustrates a side view of the spring portion of the wire spring closure device.
Fig. 13 is a front view of the wire spring closure device in an unextended state.
Fig. 14 is a top-down view of the wire spring closure device showing the top portions the bottom portions and the spring portions.
Fig. 15 is a perspective view of the upper housing portion and the lower housing portion secured by the wire spring closure device.
Fig. 16 is a perspective view of the inverted lower housing portion coupled to the upper housing portion by the wire spring closure device.
Fig. 17 is a perspective view of a portion of a sensor housing having an upper housing portion that is secured to a lower housing portion by the wire spring closure device.
Fig. 18 illustrates a methodology for securing two or more sensor housing portions together using a wire spring closure device.
Fig. 19 illustrates an example of a removal tool that can be used to remove the wire spring closure device from a housing.

### DETAILED DESCRIPTION

Various technologies pertaining to wire spring closure devices are described herein. In the following description, for purposes of explanation, numerous specific details are set forth in order to provide a thorough understanding of one or more aspects. It may be evident, however, that such aspect(s) may be practiced without these specific details. In other instances, well-known structures and devices are shown in block diagram form in order to facilitate describing one or more aspects. Further, it is to be understood that functionality that is described as being carried out by certain system components may be performed by multiple components. Similarly, for instance, a component may be configured to perform functionality that is described as being carried out by multiple components.

Moreover, the term "or" is intended to mean an inclusive "or" rather than an exclusive "or." That is, unless specified otherwise, or clear from the context, the phrase "X employs A or B" is intended to mean any of the natural inclusive permutations. That is, the phrase "X employs A or B" is satisfied by any of the following instances: X employs A; X employs B; or X employs both A and B. In addition, the articles "a" and "an" as used in this application and the appended claims should generally be construed to mean "one or more" unless specified otherwise or clear from the context to be directed to a singular form.

Sensor housings that house sensor systems such as radar, lidar, camera, sonar, etc., can be subject to extreme and varied temperature conditions. Often different portions of a sensor housing are made of different materials (e.g. plastics metals, etc.) that exhibit different characteristics when subjected to heat and cold. For example, a plastic material is likely to expand much more than a metal when exposed to heat and to contract more when exposed to cold. Additionally, fasteners used to secure housing portions together are also often made of different materials that have different expansion and contraction properties.

For instance, upper and lower housing portions may be comprised of first and second metals, and screws that fasten the two housing portions together can be comprised of a third metal. If the first and second metals contract more than the third metal in cold temperatures or the third metal expands less than the first and second metals in hot temperatures, then the screws can work themselves loose. Similarly, if one or both of the housing portions are comprised of a non-metal material that expands and contracts more than a metal fastener such as a screw or clip, then at low temperatures the metal fastener can work itself loose.

Described herein is a wire spring closure device that provides spring tension to securely and removably couple housing portions together despite temperature fluctuations. The spring feature ensures that the housing portions stay securely coupled together despite expansion and contraction when exposed to temperature extremes. The wire spring closure device is also removable to facilitate servicing the contents of the housing. In one embodiment, the housing houses one or more sensor systems (e.g., radar sensor systems, lidar sensor systems, camera sensor systems, sonar sensor systems, etc.). The spring force supplied by the wire spring closure system is sufficient to maintain an airtight and/or watertight seal between the housing portions throughout the temperature range to which the housing might be subjected. That is, the wire spring closure device is designed so that the spring tension supplied maintains a seal between the housing portions in their most contracted state at low temperatures while being able to expand to accommodate the housing portions in their most expanded state at high temperatures.

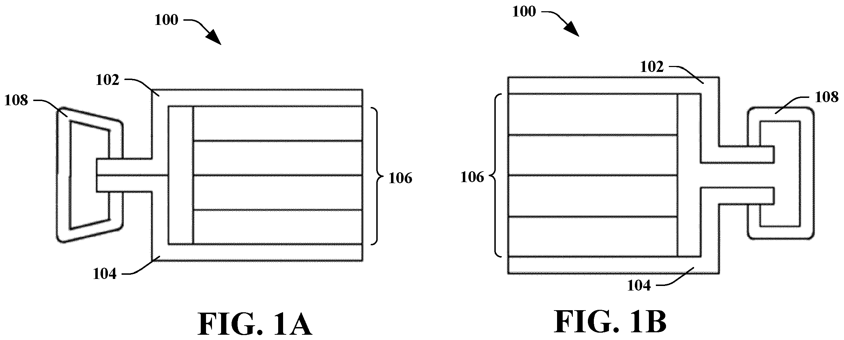

With reference now to Fig. 1A, a housing 100 is illustrated that comprises an upper portion 102 and a lower portion 104 and houses a plurality of component layers 106. The housing portions 102, 104 are secured by a clip 108 that secures the housing portions 102, 104 flush against one another. A typical sensor (e.g., a radar sensor, lidar sensor, camera sensor, sonar sensor, etc.) commonly has multiple internal layers of parts and two or more housing parts. The internal component layers 106 come with certain tolerances, as do the housing portions 102, 104 and the clip 108. When these tolerances cannot be compensated internally, a gapped alignment may occur, as shown in Fig. 1B. Therefore, a need arises for a closure mechanism that functions properly between the minimum and maximum tolerance extremes in order to compensate for expansion and contraction of the different components and materials employed in a sensor housing.

Fig. 1B shows the housing 100 wherein the housing portions 102, 104 are not held flush against one another by the clip 108 due to expansion of the component layers 106 (e.g., due to heat). This problem is overcome by the herein-described devices and systems, which provide a wire spring closure device generated from spring steel or another suitable material that can tolerate ambient conditions outside of a sensor housing and still provide sufficient force to secure sensor housing portions to each other over a desired range of conditions and extremes.

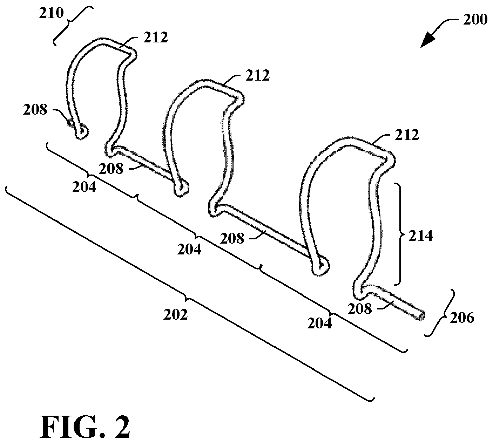

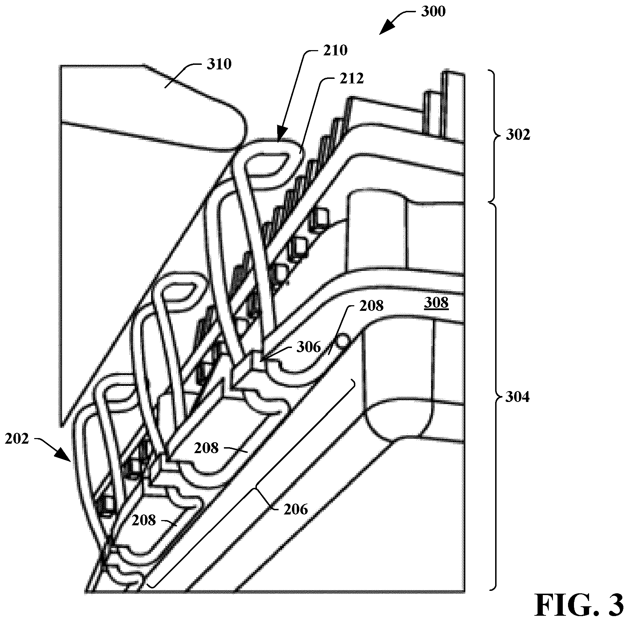

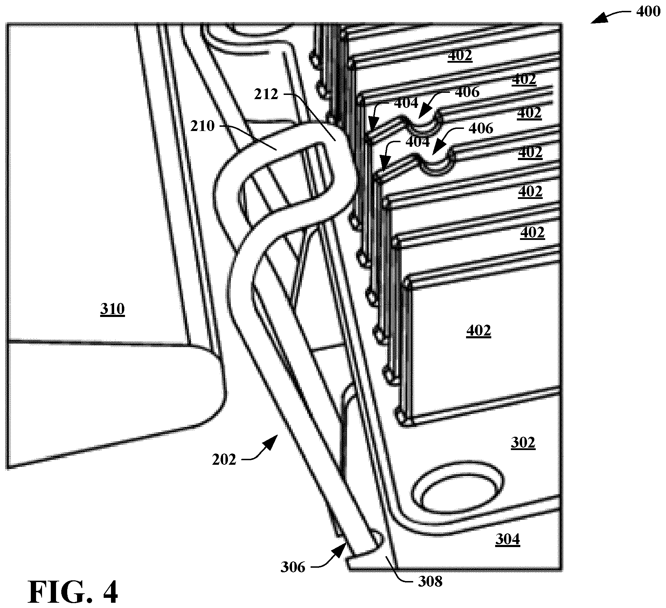

Fig. 2 is a perspective view 200 of the herein-described wire spring closure device 202. The wire spring closure device 202 comprises a plurality of clamping features 204. Each clamping feature 204 comprises a lower portion 206 which in turn comprises lower retaining bars 208 that mate with a retention structure on a lower housing portion (see Fig. 3) of a sensor housing. Each clamping feature 204 also comprises an upper portion 210 that further comprises an upper retaining bar 212 that mates with one or more retaining notches on an upper housing portion (see Fig. 4) of the sensor housing.

It will be understood that "upper" and "lower" are used herein to describe an arrangement where in the features are in an opposite orientation relative to each other and are not to be construed in a literal sense as meaning that an upper feature is necessarily positioned above a lower feature. Similarly, "upward" and "downward" are used as meaning, e.g., "toward each other" and not to be construed in a literal sense.

Spring portions 214 of the wire spring closure device 202 connect the upper retaining bars 212 to the lower retaining bars 208. When the wire spring closure device 202 is snapped into place to secure the upper and lower housing portions together, the spring portions 214 are stretched, and the tension created in the spring portions 214 biases the upper and lower housing portions toward each other to securely couple them together. It will be understood that although the wire spring closure device is illustrated with three clamping features 204, any number of clamping features 1-N (where N is an integer) can be employed.

In one embodiment, the wire spring closure device 202 comprises a bent spring steel wire (e.g., 1.4310 stainless steel wire or the like) formed using computer numerical control (CNC) or the like. The described devices and methods facilitate providing a low cost production part that is capable of automated mounting.

Fig. 3 illustrates a perspective view 300 showing an upper housing portion 302, lower housing portion 304, and the herein-described wire spring closure device 202, which together form a sensor housing system. In a non-limiting example, the upper housing portion 302 comprises a heat sink having a plurality of cooling fins disposed thereon. However, it will be understood by those of skill in the art that the upper housing portion 302 need not comprise a heat sink, but rather need only have mating features for receiving and retaining the wire spring closure device 202. According to another non-limiting example, the lower housing portion 304 can additionally or alternatively comprise a heat sink having a plurality of cooling fins disposed thereon.

The lower portion 206 of the wire spring closure device 202 is received by a plurality of receiving slots 306 positioned along a retaining structure 308 on the lower housing portion 304. A closure tool 310 is also shown, which can be employed to force the upper portion 210 of the wire spring closure device 202 against the upper housing portion 302 to lock the wire spring closure device 202 in place and secure the upper housing portion 302 to the lower housing portion 304. Once the wire spring closure device 202 is locked in place, the spring force of the device biases the upper portion 210 of the wire spring closure device 202 downward against the upper housing portion 202 and also biases lower retaining bars 208 on the lower portion 206 of the wire spring closure device 202 upward against the retaining structure 308 of the lower housing portion 304.

Fig. 4 illustrates another perspective view 400 showing the upper housing portion 302, lower housing portion 304 and wire spring closure device 206. The upper portion 210 of the wire spring closure device 202 is positioned to be mated with the upper housing portion 302. The wire spring closure device 202 is positioned in the receiving slots 306 of the retaining structure 308 of the lower housing portion 304. When activated, the closure tool 310 forces the upper portion 210 of the wire spring closure device 202 onto one or more cooling fins 402 on the upper housing portion 202. As can be seen, two of the cooling fins 402 have been modified to have a sloped or ramped edge 404 against which the upper portion 210 of the wire spring closure device 202 is pushed by the closure tool 310. As the upper portion 210 of the wire spring closure device 202 slides up the sloped edge 404 of the cooling fins 402, the wire spring closure device 202 is stretched, causing the lower retaining bars 208 of the lower portion 206 (see Fig. 2) to be biased upward against a bottom surface of the retaining structure 308. Once the upper portion 210 of the wire spring closure device 202 reaches the top of the sloped edges 404 of the cooling fins 402, the upper retaining bars 212 drop into retaining notches 406 and are locked in place. The spring tension generated by stretching the wire spring closure device 202 biases the upper housing portion 302 downward and the lower housing portion 304 upward, thereby securing the upper housing portion 302 to the lower housing portion 304.

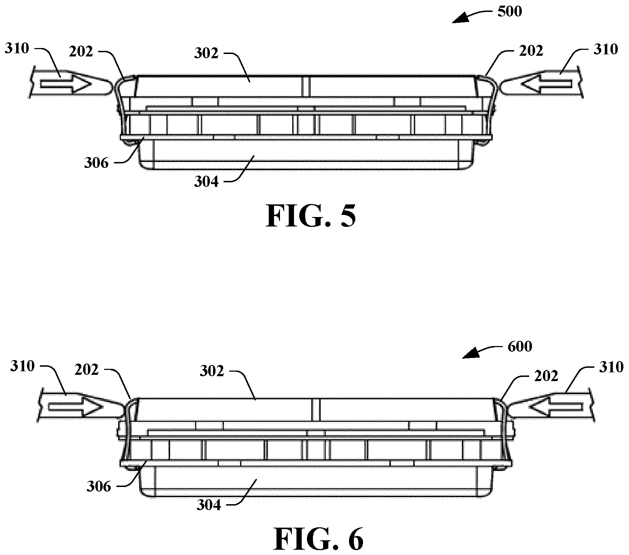

Fig. 5 shows a side view 500 the upper housing portion 302 and the lower housing portion 304 prior to engagement of the wire spring closure device 202 by the closure tools 310. Operation of the closure tools 310 can be automated or can be performed manually. In another embodiment, application of the wire spring closure device can be performed manually without the closure tool(s).

Fig. 6 shows a side view 600 of the upper housing portion 302 and the lower housing portion 304 after engagement of the wire spring closure device 202 by the closure tools 310.

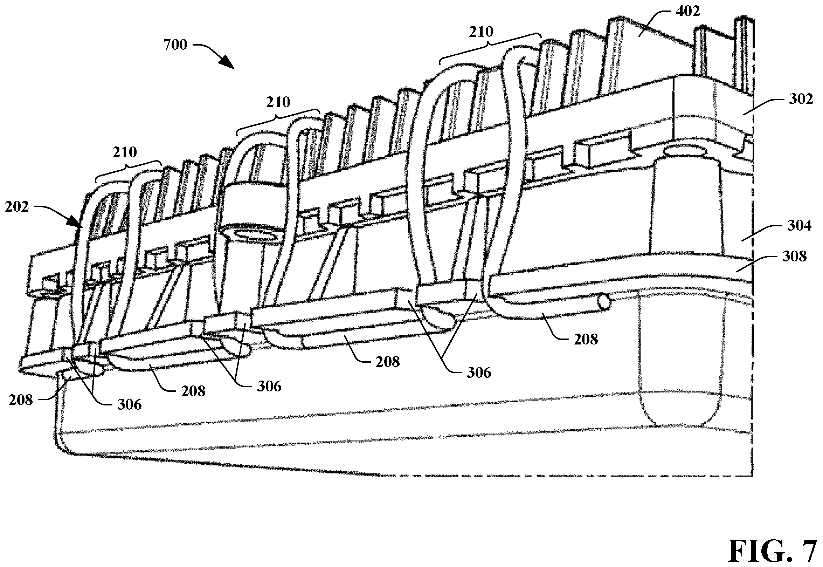

Fig. 7 illustrates another perspective view 700 of the upper housing portion 302, lower housing portion 304, and wire spring closure device 202 in a locked configuration. As can be seen, the upper portions 210 of the wire spring closure device 202 are in the locked position over the cooling fins 402. The wire spring closure device 202 is also engaged in the receiving slots 306 of the retaining structure 308 on the lower housing portion 304. With the lower retaining bars 208 biased upwards against the lower surface of the retainer structure 308, and the upper portions 210 of the wire spring closure device 202 engaged with the retaining notches (not visible in the perspective view 700) on the cooling fins 402, the spring portions 214 of the wire spring closure device 202 are stretched and generate a downward force on the upper housing portion 302 and an upward force on the lower housing portion 304 to securely fasten the upper and lower housing portions 302, 304 together.

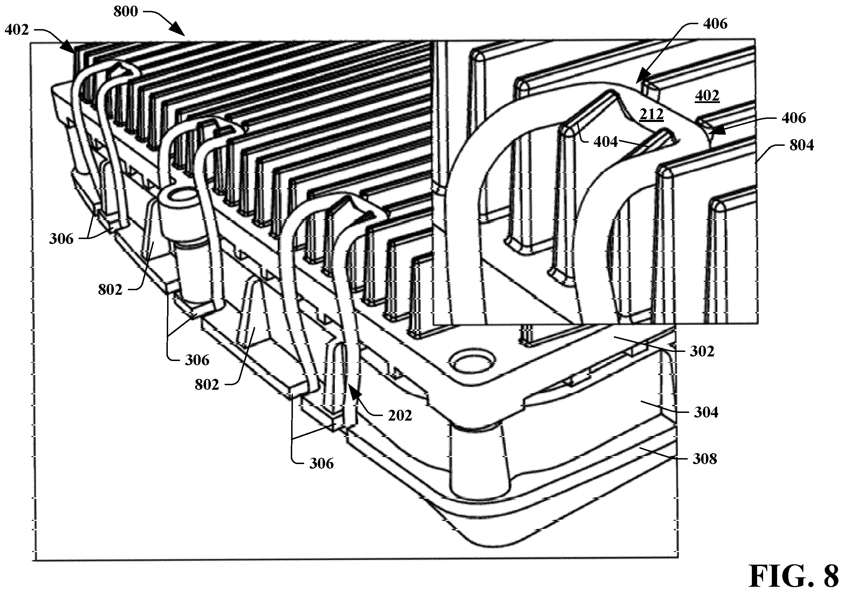

Fig. 8 is a perspective view 800 of the wire spring closure device 202 in a locked configuration securing together the upper housing portion 302 and the bottom housing portion 304. The lower portions of the wire spring closure device 202 are engaged in the respective receiving slots 306 on the restraining structure 308, and the upper portions 210 of the wire spring closure device 202 are engaged with their respective retaining notches on the cooling fins 402. Also visible in Fig. 8 are a plurality of reinforcement brackets 802 on the lower housing portion 304 that reinforce the retaining structure 308 to accommodate the upward force supplied by the wire spring closure device 202 when in its locked position.

Also shown in Fig. 8 is a pop out view 804 that shows in greater detail the engagement between the upper portion 210 of the wire spring closure device 202 and the mating features on the cooling fins 402. As can be seen, the upper retaining bar 212 is engaged in the retaining notches 406 of the cooling fins 402 after having been pushed up the sloped edges 404 of the cooling fins 402.

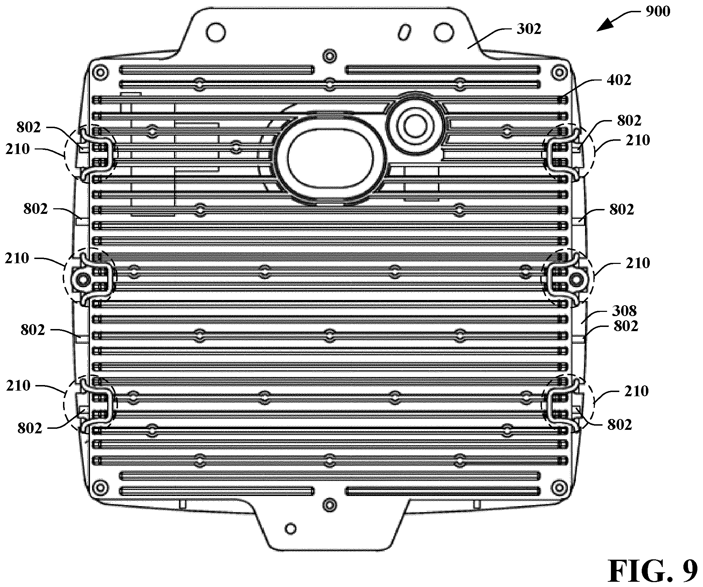

Fig. 9 is a top-down view 900 of the upper housing portion 302. Shown in this view are the cooling fins 402 and the upper portions 210 of the wire spring closure device 202 in their locked positions on the fins 402. Also shown is the retaining structure 308 of the lower housing portion 304. Reinforcement brackets 802 are visible on the retaining structure 308.

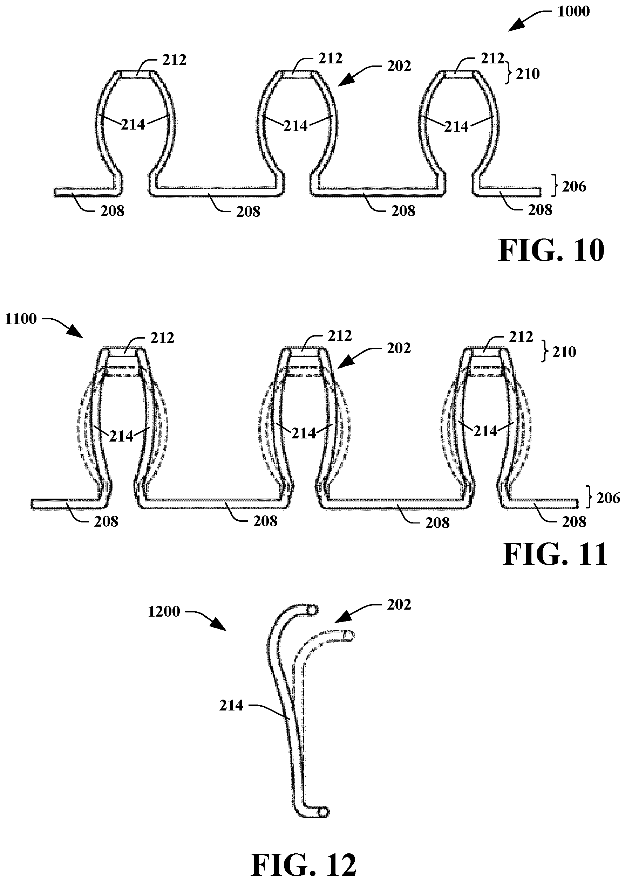

Fig. 10 is a rear view 1000 of the wire spring closure device 202 in an unlocked, unstretched state. Shown are the lower portion 206 with its lower retaining bars 208, and the upper portion 210 with its upper retaining bars 212. Also shown are spring portions 214. The spring portions 214 are shown in an unstretched state, prior to engagement with the upper and lower housing portions 302, 304.

Fig. 11 is a rear view 1100 of the wire spring closure device 202 in an extended or stretched state such as after it has been moved into a locked position. Shown are the lower portion 206 with its lower retaining bars 208, and the upper portion 210 with its upper retaining bars 212. The spring portion 214 is also shown in dashed lines in its unstretched state (e.g., as in Fig. 10) for comparison.

Fig. 12 illustrates a side view 1200 of the spring portion 214 of the wire spring closure device 202. The spring portion 214 is shown in its extended or locked state (solid lines) as well as in its contracted or unlocked state (dashed lines).

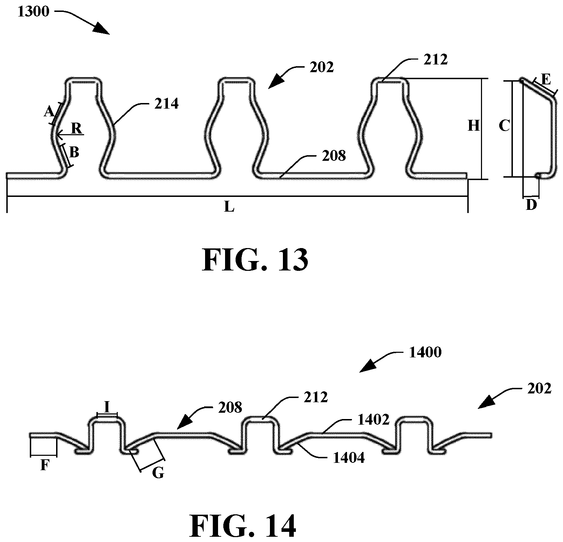

Fig. 13 is a front view 1300 of the wire spring closure device 202 having different dimensions labeled thereon. Shown are dimensions A, B, and R (radius) of the spring portion 214 of the wire spring closure device 202. Also shown are dimensions C, D, and E of the wire spring closure device 202, as well as an overall length L and overall height H. Dimensions A and B represent the lengths of the respective illustrated straight segments of the spring portion 214. Dimension C is the height of the wire spring from the center of the upper restraining bar 212 to the center of the lower restraining bar 208. Dimension D represents a difference between a rear edge of the lower retaining bars 208 and a rear edge of the upper retaining bars 212. Dimension E represents a length of the illustrated segment of the upper portion 210 of the wire spring closure device, between the spring portion 214 and the upper retaining bar 212.

Fig. 14 is a top-down view 1400 of the wire spring closure device 202 having different dimensions labeled thereon. Dimension F represents the length of a straight segment of the lower retaining bar 208. Dimension G represents a length of an angled segment of the lower retaining bar 208. Dimension I represents a length of a straight segment of the upper retaining bar.

With continued reference to Figs. 13 and 14, in a non-limiting example, the diameter of the wire of the wire spring closure device 202 is in the range of approximately, e.g., 0.5 mm - 4 mm wire. In this example, dimensions A and B may be approximately 4 mm - 6 mm. In other examples, dimensions A and B may be longer or shorter and may or may not be equal to each other. The radius R of the spring portion 214 may be, for instance, in the range of 6.5 mm - 8.5 mm. In other examples, the radius R may be larger or smaller. Dimension C may be, for instance, approximately in the range of 20mm - 30 mm, making the overall height H equal to dimension C plus the diameter of the wire used. Dimension D in this example may be in the range of approximately, e.g., 3 mm -7 mm, while dimension E may be in the range of approximately 5 mm - 8 mm. The overall length L, in this example, may be approximately 80 mm - 150 mm.

To continue this example, dimensions F and G may be in the range of approximately 4 mm - 8 mm, and dimension I may be in the range of approximately 3 mm - 6 mm. It will be understood that dimensions F and G need not be equal and in some examples may be longer or shorter than each other.

In other examples, the wire diameter and the aforementioned dimensions are smaller than described above in order to accommodate smaller housings. In still other examples, the wire diameter and aforementioned dimensions are larger than described above in order to accommodate larger housings, such as shipping containers, cargo containers, etc.

It will be appreciated that, although specific dimension ranges are described with regard to the foregoing example, the subject device is not limited thereto and any desired dimensions can be employed in order to provide a desired spring force or tension or to fit or accommodate specific housings. For example, lengthening dimensions A and B can provide a reduced spring force, while shortening dimensions A and B can provide an increased spring force (assuming all other dimensions remain constant). Similarly, increasing the radius R of the spring portion 214 can provide increased spring force, while reducing the radius R can provide decreased spring force (assuming all other dimensions remain constant). Increasing the diameter of the wire can also increase spring force while decreasing wire diameter can reduce spring force. Different wire materials can also affect the spring force of the device.

Those of skill in the art will recognize that the described wire spring closure device 202 may be designed to have different dimensions, configurations, wire thickness, etc., in order to accommodate different housing configurations and the like, and that the described wire spring closure device 202 is not limited to the dimensions, configurations, shapes, materials, etc., describe herein.

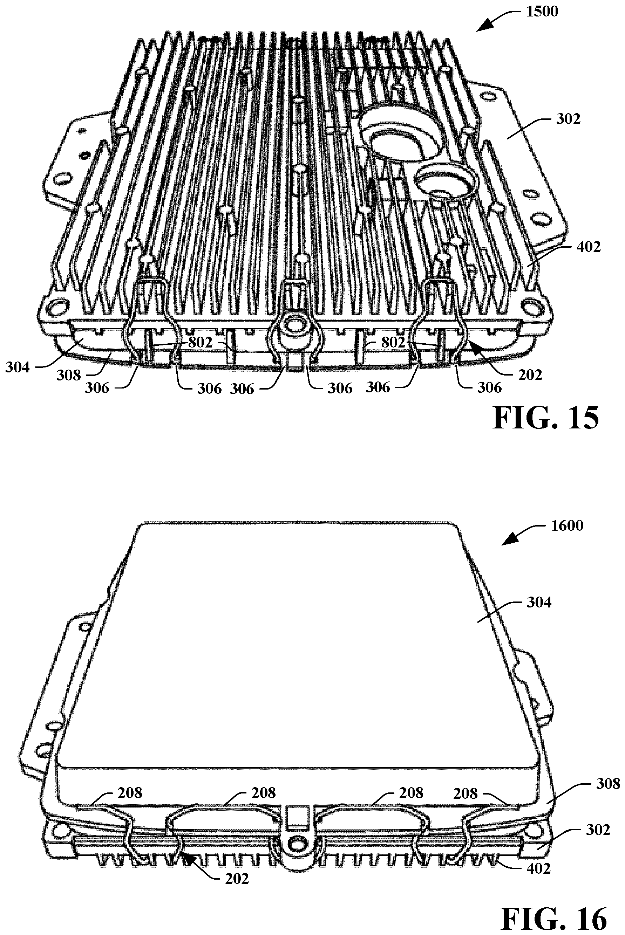

Fig. 15 is a perspective view 1500 of the upper housing portion 302 and the lower housing portion 304 secured by the wire spring closure device 202. Also visible in the perspective view 1500 are the receiving slots 306 in the retaining structure 308 and the reinforcement brackets 802. Also visible are a plurality of cooling fins 402, some of which are mated with the wire spring closure device 202 to secure the upper housing portion 302 to the lower housing portion 304.

Fig. 16 is a perspective view 1600 of the inverted lower housing portion 304 coupled to the upper housing portion 302 by the wire spring closure device 202. Also shown in the perspective view 1600 are the lower retaining bars 208 as they are biased against the retaining structure 308 of the lower housing portion 304 when the wire spring closure device 202 is in a locked or engaged state when mated with the meeting features of the cooling fins 402 on the upper housing portion 302.

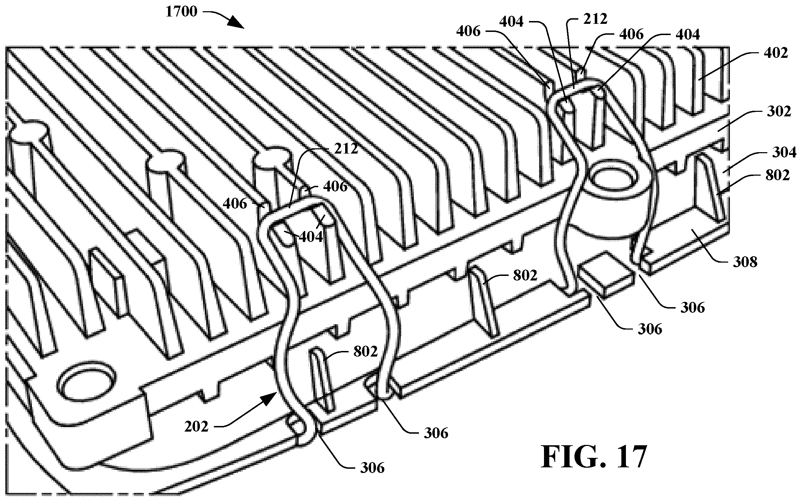

Fig. 17 is a perspective view 1700 of a portion of a sensor housing having an upper housing portion 302 that is secured to a lower housing portion 304 by the wire spring closure device 202. The wire spring closure device 202 is fitted into the receiving slots 306 of the retaining structure 308 of the lower housing 304. The upper retaining bars 212 of the wire spring closure device 202 are engaged in the retaining notches 406 on certain cooling fins 402 on the upper housing portion 302 after having been pushed along the sloped edges 404 of the respective cooling fins 402. Once engaged in the retaining notches 406, the wire spring closure device 202 is in a stretched state, and the spring tension generated when in the stretched state biases the lower retaining bars (not visible in figure 17 ) of the wire spring closure device 202 upward against the retaining structure 308 of the lower housing portion 304, and the upper retaining bars 212 of the wire spring closure device 202 downward against the cooling fins 402 of the upper housing portion 302. In this manner, the upper housing portion 302 is secured to the lower housing portion 304. Also visible in the perspective view 1700 are the reinforcement brackets 802.

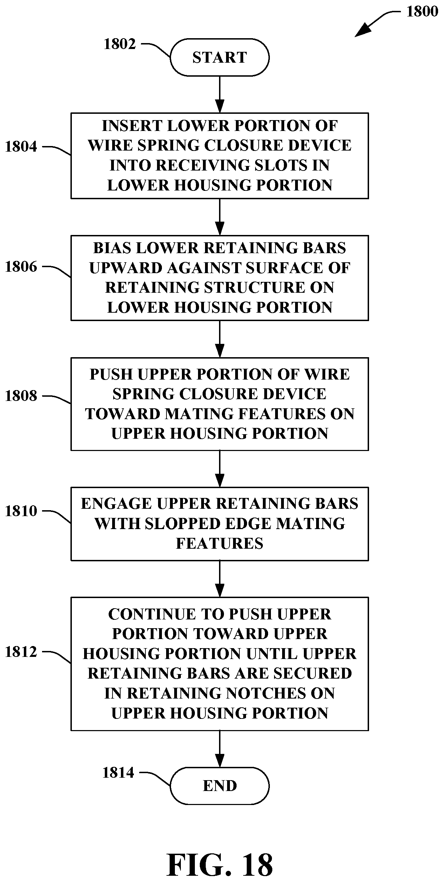

Fig. 18 illustrates an exemplary methodology relating to securing two or more sensor housing portions together using a wire spring closure device in accordance with various aspects described herein. While the methodology is shown and described as being a series of acts that are performed in a sequence, it is to be understood and appreciated that the methodology is not limited by the order of the sequence. For example, some acts can occur in a different order than is described herein. In addition, an act can occur concurrently with another act. Further, in some instances, not all acts may be required to implement a methodology described herein.

The method begins at 1802. At 1804, a lower portion of a wire spring closure device is inserted into receiving slots in a lower housing portion to be secured to an upper housing portion. In one embodiment, the receiving slots are disposed in a retaining structure on the lower housing portion. At 1806, lower retaining bars on the lower portion of the wire spring closure device are biased upward against the lower surface of the retaining structure on the lower housing portion. At 1808, an upper portion of the wire spring closure device is pushed toward mating features on the upper housing portion.

At 1810, upper retaining bars on the upper portion of the wire spring closure device are engaged with mating features on the upper housing portion. The mating features can include without limitation sloped or ramped edges on the upper housing portion against which upper retaining bars on the upper portion of the wire spring closure device are pushed. As the upper retaining bars ascend these sloped edges on the upper housing portion, spring portions of the wire spring closure device are stretched, which results in additional upward biasing force between the lower retaining bars and the lower surface of the retaining structure on the lower housing portion. Once the upper retaining bars have completely ascended the sloped edges on the upper housing portion, the upper retaining bars drop into respective retaining notches on the upper housing portion, at 1812. At this point, the wire spring closure device is in a stretched and locked position, with the upper retaining bars locked in respective retaining notches and the lower retaining bars biased firmly against the lower surface of the retaining structure on the lower housing portion.

The spring tension generated by stretching the spring portions of the wire spring closure device causes the upper retaining bars to exert a downward force on the upper housing portion and the lower retaining bars to exert an upward force on the lower housing portion, thereby securing the upward housing portion to the lower housing portion in a lockable and unlockable manner. The method terminates at 1814.

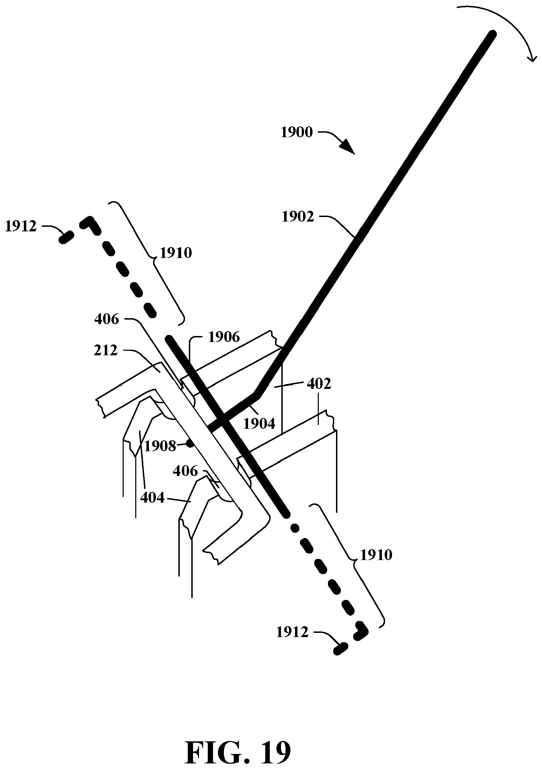

Fig. 19 illustrates an example of a removal tool 1900 that can be used to remove the wire spring closure device from a housing. The wire spring closure device is removable to facilitate opening a housing structure such as a sensor housing in order to service the contents of the housing. The removal tool comprises a handle portion 1902 that can be manipulated by an operator. In one embodiment, the handle portion 1902 is coupled to a shaft 1904 that in turn is coupled to a cross bar 1906. A pry bar portion 1908 is also provided. In another embodiment, the handle portion 1902 does not include the shaft and instead is coupled directly to the cross bar 1906.

The pry bar portion 1908 is inserted underneath the upper retaining bar 212 in its locked position in the retaining notches 406. The cross bar 1906 is positioned across the cooling fins 402 and acts as a fulcrum for the removal tool 1900. When the handle portion 1902 is moved downward toward the cooling fins 402, the removal tool 1900 pivots about the crossbar 1906, causing the pry bar portion 1908 to move upward. The upward movement of the prybar portion 1908 against the upper retaining bar 212 lifts the upper retaining bar up and out of the retaining notches 406. The upper retaining bar 212 can then slide down the sloped edges 404 of the cooling fins 402 as the wire spring closure device returns to its original unstretched state.

It will be understood that the removal tool is not limited to comprising a single pry bar portion 1908, but rather can comprise any desired number of pry bar portions. Illustrated and dashed lines in Fig. 19 are extended crossbar portions 1910 and additional pry bar portions 1912. The removal tool 1900 is illustrated as having three pry bar portions 1908, 1912 that are aligned with and engage with and the three clamping features 204 (see Fig. 2) and disengage them from the upper housing portion.

It will further be understood that the removal tool 1900 is not limited to having one or three pry bar portions but rather may have any desired number of proper portions. In one embodiment the removal tool is configured to have a number of pry bar portions equal to the number of clamping features on a given wire spring closure device. In the case where the removal tool has an even number of pry bar portions, the handle 1902 and/or shaft 1904 can be coupled to the crossbar 1906 at a point that is at or approximately at the center of the length at the crossbar 1906 or equidistant to the furthers pry bar portions.

It will further be appreciated that although Fig. 19 shows a manual removal tool 1900, the removal process can be automated, such as in a case where multiple sensor housings need to be opened in order to service their contents.

The described wire spring closure device may be employed to secure any desired type of housing or container and is not limited to a sensor housing. For instance the wire spring closure device may be employed to close other containers such as shipping containers, storage containers, food containers, or any other container for which a secure, airtight, watertight, etc. closure is desired.

Described herein are various technologies according to at least the following examples.

(A1) In an aspect, a sensor housing system includes a first housing portion, a second housing portion, and a wire spring closure device having a closure feature configured to secure the first housing portion to the second housing portion. The wire spring closure device includes a first portion comprising a first retaining bar and a spring portion coupled to the first portion. The wire spring closure device further includes a second portion coupled to the spring portion and comprising a second retaining bar.

(A2) In some embodiments of the sensor housing system of (A1), the second housing portion includes a retaining structure having receiving slots that receive the second portion of the closure feature.

(A3) In some embodiments of the sensor housing system of (A2), the second retaining bar abuts a surface of the retaining structure.

(A4) In some embodiments of the sensor housing system of (A3), the first housing portion includes retaining notches that retain the first retaining bar when in an engaged position.

(A5) In some embodiments of the sensor housing system of (A4), the first housing portion includes a sloped feature that directs the first retaining bar into the retaining notches during engagement of the closure feature.

(A6) In some embodiments of the sensor housing system of at least one of (A2)-(A5), the spring portion, when stretched in an engaged position, biases the first retaining bar toward the first housing portion and biases the second retaining bar toward the retaining structure to secure the first housing portion to the second housing portion.

(A7) In some embodiments of the sensor housing system of at least one of (A1)-(A6), the first housing portion includes a heat sink including cooling fins.

(A8) In some embodiments of the sensor housing system of (A7), the cooling fins include retaining notches that retain the first retaining bar when in an engaged position.

(A9) In some embodiments of the sensor housing system of (A8), the cooling fins include a sloped feature that directs the first retaining bar into the retaining notches during engagement of the closure feature.

(A10) In some embodiments of the sensor housing system of at least one of (A1)-(A9), the wire spring closure device is formed of stainless steel wire.

(A11) In some embodiments of the sensor housing system of (A10), the wire spring closure device is formed of 1.4310 stainless steel wire.

(A12) In some embodiments of the sensor housing system of at least one of (A1)-(A11), the sensor housing is a radar sensor housing.

(A13) In some embodiments of the sensor housing system of at least one of (A1)-(A12), the sensor housing system is employed on an autonomous vehicle.

(B 1) In another aspect, a wire spring closure device includes a closure feature including a first portion comprising a first retaining bar configured to bias a first housing portion toward a second housing portion. The wire spring closure device also includes a spring portion coupled to the first portion. The wire spring closure device also includes a second portion coupled to the spring portion and comprising a second retaining bar configured to bias the second housing portion toward the first housing portion.

(B2) In some embodiments of the wire spring closure device of (B 1), the spring portion is configured to pull the first retaining bar and the second retaining bar towards each other when stretched in an engaged position.

(B3) In some embodiments of the wire spring closure device of at least one of (B1)-(B2), the wire spring closure device is formed of stainless steel wire.

(B4) In some embodiments of the wire spring closure device of (B3), the wire spring closure device is formed of 1.4310 stainless steel wire.

(B5) In some embodiments of the wire spring closure device of at least one of (B1)-(B4), the wire spring closure device is employed on a sensor housing deployed on an autonomous vehicle.

(C1) In another aspect, a method for operating a wire spring closure device to secure a housing includes inserting a first portion of the wire spring closure device into receiving slots in a retaining structure of a first housing portion. The method further includes biasing a first retaining bar on the first portion against the retaining structure on the first housing portion. The method also includes forcing a second retaining bar along a sloped mating feature on a second housing portion until the second retaining bar engages a retaining notch in the second housing portion.

(C2) In some embodiments of the method of (C1), the housing is a radar sensor housing.

What has been described above includes examples of one or more embodiments. It is, of course, not possible to describe every conceivable modification and alteration of the above devices or methodologies for purposes of describing the aforementioned aspects, but one of ordinary skill in the art can recognize that many further modifications and permutations of various aspects are possible. Accordingly, the described aspects are intended to embrace all such alterations, modifications, and variations that fall within the spirit and scope of the appended claims. Furthermore, to the extent that the term "includes" is used in either the detailed description or the claims, such term is intended to be inclusive in a manner similar to the term "comprising" as "comprising" is interpreted when employed as a transitional word in a claim.

## Claims

1. A sensor housing system, comprising:
a first housing portion;
a second housing portion;
a wire spring closure device having a closure feature configured to secure the first housing portion to the second housing portion and comprising:
a first portion comprising a first retaining bar;
a spring portion coupled to the first portion; and
a second portion coupled to the spring portion and comprising a second retaining bar.

2. The sensor housing system of claim 1, wherein the second housing portion comprises a retaining structure having receiving slots that receive the second portion of the closure feature.

3. The sensor housing system of claim 2, wherein the second retaining bar abuts a surface of the retaining structure.

4. The sensor housing system of claim 3, wherein the first housing portion comprises retaining notches that retain the first retaining bar when in an engaged position.

5. The sensor housing system of claim 4, wherein the first housing portion comprises a sloped feature that directs the first retaining bar into the retaining notches during engagement of the closure feature.

6. The sensor housing system of any one of claims 2-5, wherein the spring portion, when stretched in an engaged position, biases the first retaining bar toward the first housing portion and biases the second retaining bar toward the retaining structure to secure the first housing portion to the second housing portion.

7. The sensor housing system of any one of claims 1-6, wherein the first housing portion comprises a heat sink comprising cooling fins.

8. The sensor housing system of claim 7, wherein the cooling fins comprise retaining notches that retain the first retaining bar when in an engaged position.

9. The sensor housing system of claim 8, wherein the cooling fins comprise a sloped feature that directs the first retaining bar into the retaining notches during engagement of the closure feature.

10. The sensor housing system of any one of claims 1-9, wherein the wire spring closure device is formed of stainless steel wire.

11. The sensor housing system of claim 10, wherein the wire spring closure device is formed of 1.4310 stainless steel wire.

12. The sensor housing system of any one of claims 1-11, wherein the sensor housing is a radar sensor housing.

13. The sensor housing system of any one of claims 1-12, employed on an autonomous vehicle.

14. A wire spring closure device, comprising:
a closure feature comprising:
a first portion comprising a first retaining bar configured to bias a first housing portion toward a second housing portion;
a spring portion coupled to the first portion; and
a second portion coupled to the spring portion and comprising a second retaining bar configured to bias the second housing portion toward the first housing portion.

15. The wire spring closure device of claim 14, wherein the spring portion is configured to pull the first retaining bar and the second retaining bar towards each other when stretched in an engaged position.
